# EUROPEAN PATENT SPECIFICATION

(11) **EP 1 792 781 B1**
(45) Date of publication and mention of the grant of the patent: **08.10.2008**
(21) Application number: 06270093.5
(22) Date of filing: 09.11.2006
(51) Int. Cl.: B60R 7/04

(54) **A switching arrangement for a storage receptacle of a motor vehicle**
Schalteranordnung für einen Lagerbehälter eines Kraftfahrzeugs
Dispostif de commutation électrique pour un réceptacle de stockage de véhicule automobile

(30) Priority: 02.12.2005 GB 0524487
(43) Date of publication of application: 06.06.2007
(73) Proprietor: JAGUAR CARS LIMITED, Whitley Coventry CV3 4LF (GB)
(72) Inventor: Popham, Thomas, Nottingham NG 2 6LT (GB); Pickering, Carl, Kenilworth Warwickshire CV8 2HU (GB)
(74) Representative: Gicquel, Olivier Yves Gérard

(56) References cited:
- WO-A-20/04017521
- JP-A- 2005 022 629

## Description

The present invention relates to a switching arrangement for a storage receptacle of a motor vehicle. In particular, the invention relates to a switching arrangement in the storage receptacle adapted to control an illumination device located, for instance, within the storage receptacle by the approach of a human hand.

It is known, for instance from W02004/017521, to install, within a vehicle compartment, an electrode forming part of a capacitor. The electrode is also connected to a detection device that monitors the capacitance to activate a switch which controls for instance an interior light. The device based upon the change in capacitance which occurs when a hand is sensing near the electrode actuates the interior light.

In addition, JP 2005022629 discloses a switching arrangement for a storage receptable of a motor vehicle according to the preamble of independent claim 1.

It is a problem with such a known arrangement that when used to control an illumination device for a storage receptacle, for instance a door bin, false triggers can be caused by (i) body parts outside the door bin e.g. leg touching the outside of the door pocket side, (ii) large or conductive objects moving inside the door panel e.g. metallic mechanical window lift mechanism and (iii) static or moving objects inside the door bin e.g. rolling bottle or CD flipping from side-to-side. These false triggers may cause unintended illumination of the door bin and thus a driver distraction.

It is an object of the present invention to provide a switching arrangement for a storage receptacle of a motor vehicle which overcomes or alleviates the aforementioned disadvantage.

According to a first aspect of the invention there is provided a switching arrangement for a storage receptacle of a motor vehicle, the receptacle defining a cavity and an access opening, the switching arrangement comprising a sensing electrode arranged on the receptacle, a capacitance measuring means comprising a frequency generator connected to the sensing electrode, a switching device arranged to operate in response to a change in the capacitance sensed by the measuring means and a shielding electrode arranged on the receptacle, the shielding electrode being connected to have the same electrostatic potential as the sensing electrode, the arrangement being such that the shielding electrode prevents operation of the switching device by an object in or adjacent the receptacle except by a hand moving towards or away from the access opening.

Preferably, the sensing electrode and the shielding electrode are connected in use to a common alternating current frequency generator.

The sensing electrode may be formed by a plurality of electrodes.

According to a second aspect of the invention there is provided an inner trim panel for a motor vehicle, the trim panel having a storage receptacle, the receptacle including a switching arrangement which is in accordance the first aspect of the invention.

Preferably, the switching device is in use connected to an illumination device arranged to illuminate the interior of the receptacle.

Preferably also the inner trim panel is a trim panel of a vehicle door.

Preferably, the shielding electrode includes a first shielding electrode arranged on the receptacle and a second shielding electrode arranged on the trim panel so that the first shielding electrode prevents operation of the switching device by an object located between the inner door panel and an exterior door panel which is in use connected to the inner door panel.

The invention will now be described by way of example with reference to the accompanying drawings of which: -
Fig.1 is a perspective view of a trim panel of a vehicle door having a storage receptacle including a switching arrangement according to a first arrangement of the present invention;
Fig.2 is a schematic cross-section on the line A-A in Fig.1 with a schematic representation of the switching arrangement located within the storage receptacle, and
Fig.3 is a similar view to Fig.2 showing a modification of the switching arrangement, and
Fig.4 is a similar view to Fig.2 showing another modification of the switching arrangement.

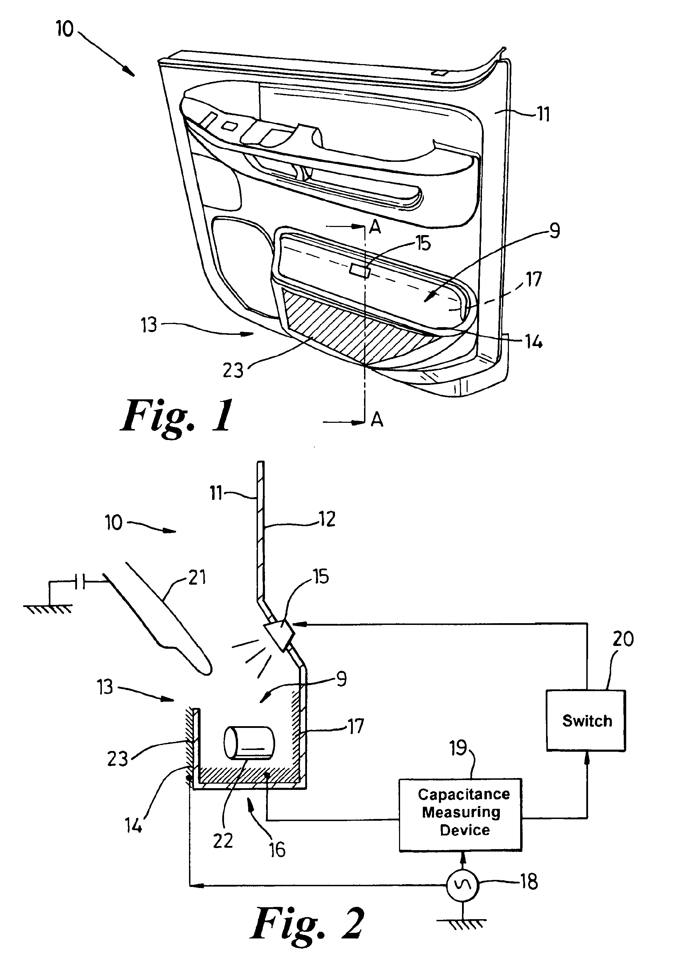

With reference to the Figs.1 to 2, there is shown an inner trim panel 10 of a vehicle door, in particular for the driver side of a vehicle. The trim panel 10 has a body having a front side 11 and a back side 12 opposite the front side 11. The back side 12 of the trim panel 10 is hidden from view by an exterior door panel (not shown) when the trim panel is attached to a door frame (not shown).

The trim panel 10 also has in it's lower part a storage receptacle 13 that projects from the front side 11 and substantially extends horizontally across a major portion of the width of the panel 10. The storage receptacle 13 has a front panel 14 and an access opening 9. The storage receptacle 13 is in this example formed as part of the trim panel 10.

An illumination device 15 and a switching arrangement 16 are also attached to the trim panel 10. The illumination device 15 includes at least one light source located in this example within the storage compartment 13.

The switching arrangement 16 includes a sensing electrode 17 which is formed in this example of foil strip. The sensing electrode 17 is coated on the front side 11 of the trim panel 10 in such a way that the sensing electrode 17 covers the region of the trim panel 10 which defines a back side for the storage receptacle 13. The sensing electrode 17 is connected to an output of an alternating current frequency generator 18 and also to a capacitance measuring means 19 which control a switching device 20 connected to the illumination device 15. The capacitance measuring means 19 includes, in a known manner, a threshold circuit, a multiplexer and amplifier.

Thus, in a conventional manner, when an operator moves his hand 21 towards the sensing electrode 17 then the current is pulled from the electrode into the body and will be detected by the capacitance measuring means 19 of the sensing electrode 17 generating output signal which will control lighting of the illumination device 15 according to a change of capacitance signal.

If the operator places a full tin can 22 in the storage receptacle 13 there is no change of capacitance signal measured at the sensing electrode 17, as the tin can 22 has a relative capacitance close to that of a hand. Hence the illumination device 15 is likely be keep turning on or be turned on when the can moves causing a driver distraction. To overcome this problem the switching arrangement 16 further includes a shielding electrode 23. The shielding electrode 23 is also formed in this example of foil strip which is coated on the exterior surface of the front panel 14 of the storage receptacle 13. The shielding electrode 23 is also connected to the AC frequency generator 18. A trim piece (not shown), such as carpet or fabric is attached to the front panel to hide the shielding electrode and hence provide a more pleasing appearance.

Since the sensing electrode 17 and the shielding electrode 23 are connected to the same output signal of the frequency generator 18, the sensing electrode 17 and the shielding electrode 23 have the same electrostatic potential. This prevents the flow of current between the electrodes 17 and 23, thereby negating the capacitance of the sensing electrode within the storage receptacle 13 as the sensing electrode 17 and the shielding 23 surround the storage receptacle 13. Hence, when the operator places an object for instance a tin can within the storage receptacle, the hand entering through the opening 15 of the storage receptacle will pull the current from the electrodes into the body and will be detected by the capacitance measuring means 19 of the sensing electrode generating output signal which will turn on the switching device and thus the light source(s) of the illumination device 15. When the hand leaves the storage receptacle without the object, the capacitance measuring means 19 will detect a capacitance change and interpret this signal as a control signal to turn off the switching device and thus light source(s). The relative capacitance of the tin can within the door bin does not affect the electric field as the sensing electrode 17 is negated inside the storage receptacle 13 by the shielding electrode 23 and the tin can is insulated from the ground by being in contact with one of the electrodes avoiding thus a false trigger of the illumination device 15. It will be appreciated that as the shielding electrode 23 is not connected to a capacitance measuring means any motion of a hand or other body parts over this electrode 23 will not be interpreted.

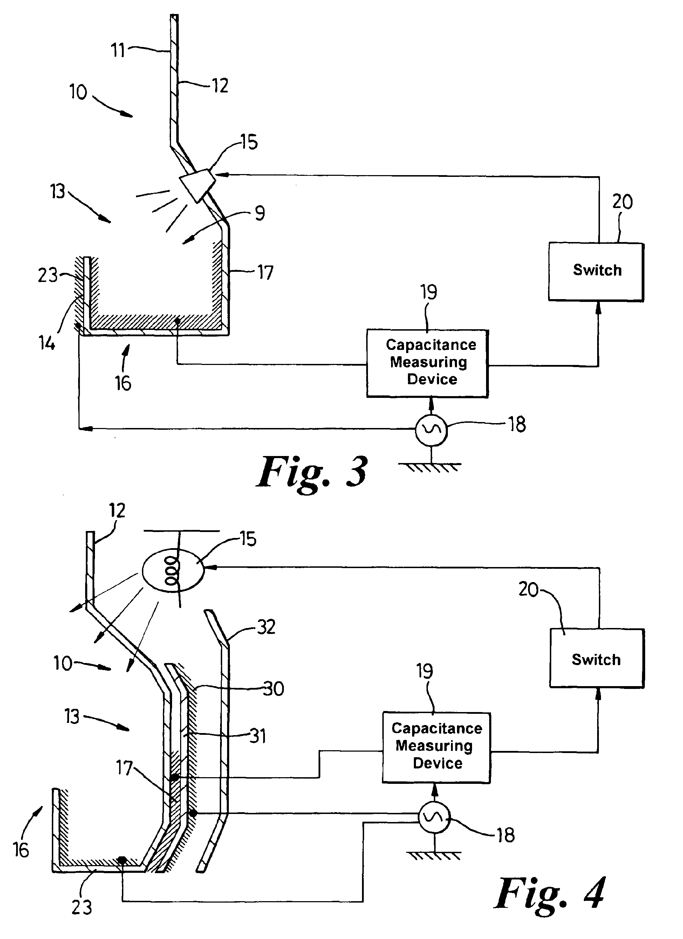

In a modification, the sensing electrode 17 is coated on the trim panel 10 in such a way that the sensing electrode surrounds the storage bin as shown in Fig. 3. In such an arrangement the shielding electrode is insulated from the sensing electrode, e.g. by coating the sensing electrode inside the storage receptacle and the shielding electrode outside the front panel 14. Such an arrangement ensures that a hand entering close to the front panel will be detected by the sensing electrode 17 even if the opening 15 of the storage receptacle is wide.

In another modification as shown in Fig. 4, the sensing electrode 17 is coated on the back side 12 of the trim panel 10 and the shielding electrode 23 is coated inside the receptacle 13. In this alternative a second shielding electrode 30 is coated on the top of the sensing electrode 17. A dielectric insulating layer 31 is interposed between the sensing electrode 17 and the second shielding electrode 30 to insulate the second electrode 30 from the sensing electrode 17. Such an arrangement ensures that an object moving between the inner door panel 10 and the exterior door panel 32, for instance a window lift mechanism, will not be detected by the sensing electrode 17 causing false triggers of the switching device.

Although the sensing arrangement has been described herein in relation to a storage receptacle of a door trim panel it will be appreciated that the sensing device may be arranged within other inner trim panels including a storage receptacle elsewhere on the vehicle. Furthermore, it will be appreciate that each electrode may comprise more than one foil strip or other conductive materials for different shaped and sized storage receptacles.

## Claims

1. A switching arrangement (16) for a storage receptacle (13) of a motor vehicle, the receptacle (13) defining a cavity and an access opening (9), the switching arrangement (16) comprising a sensing electrode (17) arranged on the receptacle (13), a capacitance measuring means (19) comprising an frequency generator (18) connected to the sensing electrode (17), a switching device (20) arranged to operate in response to a change in the capacitance sensed by the measuring means (19), **characterised in that** a shielding electrode (23) is arranged on the receptacle (13), the shielding electrode (23) being connected to have the same electrostatic potential as the sensing electrode (17), the arrangement being such that the shielding electrode (23) prevents operation of the switching device (20) by an object in or adjacent the receptacle except by a hand moving towards or away from the access opening (9).

2. A switching arrangement as claimed in claim 1 in which the sensing electrode (17) and the shielding electrode (23) are connected in use to a common alternating current frequency generator (18).

3. A switching arrangement claimed in claim 1 or claim 2 in which the sensing electrode (17) is formed by a plurality of electrodes.

4. An inner trim panel (10) for a motor vehicle, the trim panel (10) having a storage receptacle, the receptacle including a switching arrangement (16) which is in accordance with any one of claims 1 to 3.

5. A trim panel as claimed in claim 4 in which the switching device (20) is in use connected to an illumination device (15) arranged to illuminate the interior of the receptacle (13).

6. A trim panel as claimed in any one of claims 4 to 6 in which the trim panel is an inner trim panel (10) of a vehicle door.

7. A trim panel as claimed in claim 6, the inner door (10) being in use connected to an exterior door panel (32), in which the shielding electrode includes a first shielding electrode (23) arranged on the receptacle and a second shielding electrode (30) arranged on the trim panel (10) so that the first shielding electrode prevents operation of the switching device (20) by an object located between the inner door panel (10) and the exterior door panel (32).

## Patentansprüche

1. Schaltanordnung (16) für einen Lagerbehälter (13) eines Kraftfahrzeugs, der einen Hohlraum und eine Zugriffsöffnung (9) definiert, wobei die Schaltanordnung (16) eine am Behälter (13) angeordnete Fühlerelektrode (17), ein Kapazitätsmessmittel (19) mit einem mit der Fühlerelektrode (17) verbundenen Frequenzgenerator (18) und eine Schaltvorrichtung (20) umfasst, die so angeordnet ist, dass sie als Reaktion auf eine durch das Messmittel (19) erfasste Änderung in der Kapazität betätigt wird, **dadurch gekennzeichnet, dass** eine Abschirmelektrode (23) am Behälter (13) angeordnet ist, die so angeschlossen ist, dass sie dasselbe elektrostatische Potential wie die Fühlerelektrode (17) hat, wobei die Anordnung derart ist, dass die Abschirmelektrode (23) verhindert, dass die Schaltvorrichtung (20) durch ein Objekt in oder neben dem Behälter außer einer Hand, die sich zur Zugriffsöffnung (9) hin- oder von ihr wegbewegt, betätigt wird.

2. Schaltanordnung nach Anspruch 1, wobei die Fühlerelektrode (17) und die Abschirmelektrode (23) im Gebrauch mit einem gemeinsamen Wechselstromfrequenzgenerator (18) verbunden sind.

3. Schaltanordnung nach Anspruch 1 oder 2, wobei die Fühlerelektrode (17) durch mehrere Elektroden gebildet wird.

4. Inneres Verkleidungsteil (10) für ein Kraftfahrzeug, wobei das Verkleidungsteil (10) einen Lagerbehälter hat, der eine Schaltanordnung (16) nach einem der Ansprüche 1 bis 3 aufweist.

5. Verkleidungsteil nach Anspruch 4, wobei die Schaltvorrichtung (20) im Gebrauch mit einer Beleuchtungsvorrichtung (15) verbunden ist, die zur Beleuchtung des Inneren des Behälters (13) angeordnet ist.

6. Verkleidungsteil nach einem der Ansprüche 4 bis 6, wobei das Verkleidungsteil ein inneres Verkleidungsteil (10) einer Fahrzeugtür ist.

7. Verkleidungsteil nach Anspruch 6, wobei das innere Türblatt (10) im Gebrauch mit einem äußeren Türblatt (32) verbunden ist, wobei die Abschirmelektrode eine am Behälter angeordnete erste Abschirmelektrode (23) und eine am Verkleidungsteil (10) angeordnete zweite Abschirmelektrode (30) aufweist, so dass die erste Abschirmelektrode verhindert, dass die Schaltvorrichtung (20) durch ein sich zwischen dem inneren Türblatt (10) und dem äußeren Türblatt (32) befindendes Objekt betätigt wird.

## Revendications

1. Configuration (16) de commutation pour réceptacle (13) de stockage d'un véhicule automobile, le réceptacle (13) définissant une cavité et une ouverture (9) d'accès, la configuration (16) de commutation comportant une électrode (17) de détection disposée sur le réceptacle (13), un moyen (19) de mesure de capacité comportant un générateur (18) de fréquence relié à l'électrode (17) de détection, un dispositif (20) de commutation disposé de façon à fonctionner en réaction à une variation de la capacité détectée par le moyen (19) de mesure, **caractérisé en ce qu'**une électrode (23) de protection est disposée sur le réceptacle (13), l'électrode (23) de protection étant branchée de façon à présenter le même potentiel électrostatique que l'électrode (17) de détection, la configuration étant telle que l'électrode (23) de protection empêche le dispositif (20) de commutation d'être actionné par un objet situé à l'intérieur ou au voisinage du réceptacle (13), à l'exception d'une main s'approchant ou s'éloignant de l'ouverture (9) d'accès.

2. Configuration de commutation selon la revendication 1, dans laquelle l'électrode (17) de détection et l'électrode (23) de protection sont reliées en cours d'utilisation à un générateur (18) de fréquence commun à courant alternatif.

3. Configuration de commutation selon la revendication 1 ou la revendication 2, dans laquelle l'électrode (17) de détection est formée d'une pluralité d'électrodes.

4. Panneau (10) de garniture intérieure pour véhicule automobile, le panneau (10) de garniture comportant un réceptacle de stockage, le réceptacle comprenant une configuration (16) de commutation selon l'une quelconque des revendications 1 à 3.

5. Panneau de garniture selon la revendication 4, dans lequel le dispositif (20) de commutation est, en cours d'utilisation, relié à un dispositif (15) d'éclairage disposé de façon à éclairer l'intérieur du réceptacle (13).

6. Panneau de garniture selon l'une quelconque des revendications 4 à 6, dans lequel le panneau de garniture est un panneau (10) de garniture intérieure d'une portière de véhicule.

7. Panneau de garniture selon la revendication 6, le panneau intérieur (10) de portière étant, en cours d'utilisation, relié à un panneau extérieur (32) de portière, dans lequel l'électrode de protection comprend une première électrode (23) de protection disposée sur le réceptacle et une deuxième électrode (30) de protection disposée sur le panneau (10) de garniture de telle sorte que la première électrode de protection empêche le dispositif (20) de commutation d'être actionné par un objet situé entre le panneau intérieur (10) de portière et le panneau extérieur (32) de portière.
